# EUROPEAN PATENT SPECIFICATION

(11) **EP 1 154 049 B1**
(45) Date of publication and mention of the grant of the patent: **09.04.2008**
(21) Application number: 99961384.7
(22) Date of filing: 24.12.1999
(51) Int. Cl.: C30B 29/36, C30B 25/00, C30B 25/20, C30B 23/00, C30B 23/02, B24B 53/00

(54) **METHOD OF MANUFACTURING SINGLE-CRYSTAL SILICON CARBIDE**
VERFAHREN ZUR HERSTELLUNG EINES EINKRISTALLSILIZIUMKARBIDS
PROCEDE DE FABRICATION DE MONOCRISTAL DE CARBURE DE SILICIUM

(30) Priority: 25.12.1998 JP 36856698
(43) Date of publication of application: 14.11.2001
(73) Proprietor: SHOWA DENKO KABUSHIKI KAISHA, Tokyo 105-8518 (JP)
(72) Inventor: SHIGETO, Masashi Showa Denko K.K. Ctr.Res.Lab., Chiba-shi, Chiba 267-0056 (JP); YANO,Kotaro Showa Denko K.K. Ctr.Res.Lab., Chiba-shi, Chiba 267-0056 (JP); NAGATO, Nobuyuki Showa Denko K.K. Ctr.Res., Chiba-shi, Chiba 267-0056 (JP)
(74) Representative: Strehl Schübel-Hopf & Partner
(86) International application number: PCT/JP1999/007298
(87) International publication number: WO 2000/039371

(56) References cited:
- EP-A- 0 576 937
- WO-A1-91/06116
- JP-A- 6 188 163
- JP-A- 7 097 299
- JP-A- 10 182 297
- JP-A- 10 291 899
- PATENT ABSTRACTS OF JAPAN vol. 018, no. 527 (E-1613), 5 October 1994 (1994-10-05) & JP 06 188163 A (TOYOTA CENTRAL RES & DEV LAB INC), 8 July 1994 (1994-07-08)
- TADASHI OMORI: 'Influence of crystal growth direction in ELID mirror-polishing process of SiC single-crystal' JOURNAL OF JAPAN SOCIETY GRINDING ENGINEERS (SHIRYU KAKO GAKKAI, TOKYO) vol. 41, no. 3, March 1997, JAPANESE, pages 106 - 108, XP002929914

## Description

### Technical Field

The present invention relates to a process for producing silicon carbide single crystals to be used for hard electronics. Hard electronics is a general term for wide band gap semiconductors of silicon carbide or diamond which have physical properties exceeding those of silicon. Of these, silicon carbide is superior to silicon in terms of its high heat resistance, thermal conductivity and mechanical strength, as well as its insulating dielectric breakdown voltage and carrier saturated drift velocity, and therefore its importance is increasing for potential uses in the field of energy electronics represented by power devices, and information electronics which is primarily directed towards high frequency communications.

### Background Art

Most silicon carbide single crystals are produced by sublimation. This process involves placing the starting silicon carbide powder into one end of a cylindrical graphite crucible while situating a planar silicon carbide single crystal as the seed crystal in another end of the crucible, and heating the crucible to between 1800°C and 2400°C in a reduced pressure or ordinary pressure atmosphere of an inert gas such as argon, using heating means such as high frequency induction heating or resistance heating. For efficient sublimation, the heating conditions are set so that the temperature of the seed crystal is lower than the starting powder temperature.

The seed crystal used is generally a hexagonal planar single crystal randomly obtained by the Acheson process or Lely process or a planar-worked single crystal obtained by sublimation. The Acheson process is a process for obtaining silicon carbide by reacting silica (SiO₂) and coke at high temperature, originally for the purpose of producing common industrial materials such as grinding materials and refractory materials. Single crystals randomly obtained in the process of production are classified according to crystal orientation and crystal surface for utilization as seed crystals in sublimation, and they must therefore be subjected to machining such as cutting or polishing. Even when using silicon carbide crystals obtained by sublimation, machining such as cutting and polishing is necessary to use the obtained single crystal ingot as a seed crystal.

However, since silicon carbide has such high hardness that it is utilized as a polishing material itself, the machining time required for cutting is a difficult problem. Silicon carbide is also chemically stable, making it difficult to apply in polishing steps of chemical etching that facilitates removal of machining damage commonly used for silicon semiconductors. The machining damage and machining deformation of seed crystals machined with existing processing machinery can be confirmed as damage by etching by KOH heated to approximately 500°C, and for example, even when the damage is not clearly visible on the surface immediately after polishing, innumerable defects can be seen after KOH etching, indicating that machining damage and deformation remains in the single crystal.

When the silicon carbide has undergone homoepitaxial growth by chemical vapor deposition on a silicon carbide single crystal machined with existing processing machinery, the machining damage and machining deformation sometimes leads to visible linear defects in the epitaxial layer, and it is thought that they affect the single crystal growth to some degree even in the case of single crystal growth by sublimation. The factor that most seriously affects the crystal quality is the crystal defect known as "micropipes" generated during silicon carbide single crystal growth, and the presence of such defects can adversely affect the final properties and yield of products by resulting in a reduced withstand voltage of the circuit and current leakage during device manufacture.

In an attempt to prevent generation of such micropipes, much study has been devoted to the causative factors and numerous solutions have been proposed. For example, it has been suggested in the literature that impurity contamination or else carbon or silicon clusters in the silicon carbide starting material are the cause of generation of micropipes, while another school of thought holds that the micropipes with physical surfaces are generated in bulk crystals as a release for dislocation strain occurring during crystal growth. In light of these explanations, there have currently been devised methods of reducing micropipes by polishing or washing of the seed crystals prior to growth, or by such means as stepwise growth methods achieved by altering the crystal face orientation.

When silicon carbide single crystals are grown by the aforementioned conventional methods, micropipes have been found to be present in a number of 10² to 10³/cm², running in the direction of crystal growth. These micropipes are generated along with spiral growth, which is the typical growth mode of silicon carbide.

The present invention provides silicon carbide seed crystals with no damage or deformation on the initial growth surface, for the purpose of achieving growth of silicon carbide single crystals free of defects such as the aforementioned micropipes, in methods whereby silicon carbide single crystals are grown on seed crystals, such as sublimation, or in the method described in WO99/14405 by Showa Denko Co., Ltd. wherein a silicon starting material is vaporized and reacted with a carbon starting material to produce a silicon carbide single crystal (hereunder referred to as "silicon gas/carbon reaction").

Except for a small number of types such as crystals obtained by the Acheson process or Lely process, seed crystals of the prior art are usually used after cutting or polishing machining of the single crystals grown by sublimation. However, cutting with diamond grinding wheels or polishing with free abrasive particles using lapping machines has been plagued with the problems of machining damage and machining deformation introduced into the crystals, and when these are used as seed crystals, defects such as micropipes are generated in the growing crystals.

### Disclosure of the Invention

In the course of diligent efforts directed toward solving the aforementioned problems of the prior art, the present inventors have completed the present invention upon finding that, if electrolytic in-process dressing grinding (hereunder abbreviated to "ELID grinding") is employed for machining of a seed crystal for a silicon carbide single crystal, the finished surface of the machined single crystal has no machining damage or machining deformation, and that if the crystal is used for growth of a silicon carbide single crystal, it is possible to obtain a silicon carbide single crystal with a drastically reduced level of defects such as micropipes.

In other words, the present invention resides in a process for producing a silicon carbide single crystal which is a process whereby a silicon carbide single crystal is grown on a seed crystal substrate, characterized in that a silicon carbide crystal machined by ELID grinding is used as the seed crystal, and more specifically, the following are provided.
(1) A process for producing a silicon carbide single crystal whereby a silicon carbide single crystal is grown on a seed crystal substrate, characterized in that the process for producing the silicon carbide single crystal comprises
   setting, as a seed crystal in a crystal growth vessel, a silicon carbide crystal which has been machined by electrolytic in-process dressing grinding and which has been treated with hydrofluoric acid, and
   growing the silicon carbide single crystal on the seed crystal.
(2) A process for producing a silicon carbide single crystal according to (1), wherein the seed crystal is a silicon carbide single crystal obtained by the Acheson or Lely process and is machined by electrolytic in-process dressing grinding.
(3) A process for producing a silicon carbide single crystal according to (1), wherein the seed crystal is a silicon carbide single crystal grown by sublimation or silicon gas/carbon reaction and machined by electrolytic in-process dressing grinding.
(4) A process for producing a silicon carbide single crystal according to (1), wherein the electrolytic in-process dressing grinding includes electrolytic in-process dressing lapping.
(5) A process for producing a silicon carbide single crystal according to (1) to (4), wherein the electrolytic in-process dressing grinding includes repeated lap grinding with a metal bonded or metal resin bonded grinding wheel employing abrasive particles in the range of #300-#3,000,000 based on the JISR6001 standard.
(6) A process for producing a silicon carbide single crystal according to (1) to (5), wherein the crystal growth surface of the seed crystal for the silicon carbide crystal machined by electrolytic in-process dressing grinding has an average surface roughness of no greater than 20 nm.
(7) A process for producing a silicon carbide single crystal whereby a silicon carbide single crystal is grown on a seed crystal substrate, characterized in that the process for producing the silicon carbide single crystal comprises
   setting, as a seed crystal in a crystal growth vessel, silicon carbide crystal which has been machined by electrolytic in-process dressing grinding and which has been treated with hydrofluoric acid,
   heating a silicon carbide starting material placed in the crystal growth vessel and sublimating the silicon carbide to form a sublimated gas, and
   transporting the sublimated gas over the seed crystal to cause growth of a silicon carbide single crystal on the seed crystal.
(8) A process for producing a silicon carbide single crystal whereby a silicon carbide single crystal is grown on a seed crystal substrate, characterized in that the process for producing the silicon carbide single crystal comprises
   setting, as a seed crystal in a crystal growth vessel, a silicon carbide crystal which has been machined by electrolytic in-process dressing grinding and which has been treated with hydrofluoric acid,
   heating to melt the silicon material set in the crystal growth vessel to form silicon vapor,
   contacting the silicon vapor with a heated carbon material set between the silicon material and the seed crystal to form a silicon carbide-forming gas, and
   transporting the silicon carbide-forming gas over the seed crystal to cause growth of a silicon carbide single crystal on the seed crystal.
(9) A silicon carbide single crystal obtained by the production process of any of (1) to (8).

### Brief Description of the Drawings

Fig. 1 is a drawing illustrating ELID grinding.
Fig. 2 is an illustration showing an example of a single crystal growth apparatus based on sublimation, used according to the invention.
Fig. 3 is an illustration showing an example of a single crystal growth apparatus based on a silicon gas/carbon reaction, used according to the invention.

### Best Mode for Carrying Out the Invention

The machining by ELID grinding as applied according to the present invention allows polishing of difficult-to-polish materials such as silicon carbide using a fine abrasive, and provides an effect of much lower machining damage and machining deformation on polishing materials than conventional machining methods.

ELID grinding is a method for polishing of metal bonded grinding wheel surfaces with electrolytic dressing, by using as the anode a metal bonded grinding wheel and using as the cathode an electrode paired with the metal bonded grinding wheel, with application of a direct current pulse voltage between the metal bonded grinding wheel and the electrode, and the method is used for cutting and polishing. In this method, the machining tool used may be a cutting blade with a metal bonded grinding wheel or a lapping disk. The cutting blade would be used for cutting, and the lapping disk used for lap machining.

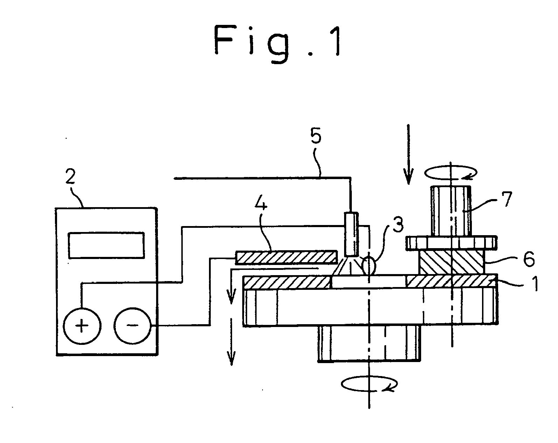

An example of ELID grinding will now be explained with reference to Fig. 1. In Fig. 1, a metal bonded grinding wheel 1 as the anode is connected to a power source 2 through a feed conductor 3. In this example, the metal bonded grinding wheel 1 is a rotating lapping disk. A cathode 4 is positioned opposite the metal bonded grinding wheel 1, and is also connected to the power source 2. An electrolyte solution is supplied between the metal bonded grinding wheel 1 (anode) and the cathode 4 from an electrolyte solution supply tube 5, and therefore during the machining process the surface of the metal bonded grinding wheel 1 is constantly kept electrolytically dressed, so that most of the problems of the shape and control of the grinding wheel surface that occur with anchored abrasive are solved. Because it is sufficient for the electrolyte solution to be between both electrodes, the metal bonded grinding wheel 1 and the cathode 4 may even be immersed in the electrolyte solution. The article to be machined 6 is pressed against the surface of the constantly dressed fresh grinding wheel surface of the metal bonded grinding wheel 1, and is thereby polished by the metal bonded grinding wheel 1. The article to be machined 6 may also be rotated, or pressing means 7 may be used to maintain constant pressure. Fig. 1 is an example where ELID is combined with lapping, but it may also be combined with cutting, as mentioned above.

When such ELID grinding is employed, the metal bonded sections of the grinding wheel are constantly kept electrolytically dressed during the machining, and this constant dressing of the grinding wheel prevents clogging and avoids an unnecessary load on the article to be cut since the abrasive grits are in constant contact with the article to be cut. As a result of this effect, an abrasive on the submicron level may be used, and mirror finishing can be accomplished by cutting.

According to the invention, the silicon carbide single crystal used as the seed crystal must be machined and the silicon carbide grown as a single crystal on the machining surface. When machining damage or machining deformation is present on the machining surface, the crystallinity is not maintained and crystal defects can result, but it was found that machining by ELID grinding can reduce such damage and deformation compared to prior art methods, and can minimize the degree of defects such as micropipes during crystal growth.

The finishing of the surfaces of silicon carbide single crystals used as seed crystals for machining by ELID grinding cannot be specified for all cases, but it is usually carried out to an average surface roughness no greater than 20 nm, and preferably no greater than 10 nm.

The surface of the silicon carbide seed crystal obtained by machining with ELID grinding according to the invention is characterized by having low machining damage and machining deformation. For example, it is possible to eliminate damage visible under a fluorescent lamp, or to eliminate damage that is visible under green light or even condensed light of approximately 100,000 lux, after machining. Similarly, when the silicon carbide single crystal is grown on a silicon carbide seed crystal obtained by machining with ELID grinding, no crystal defects are visible on the crystal surface and virtually no defects are found even with KOH etching. For example, micropipes can be limited to no more than 50 per cm², or even no more than 10 per cm².

According to the invention, machining by ELID grinding can not only reduce the surface roughness of the silicon carbide single crystal more easily than by other polishing methods, but also reduces machining damage on the surface of the silicon carbide single crystal compared to other polishing methods, where the surface roughness is the same. It is believed that the reason for the notable reduction in the number of defects of the silicon carbide single crystal grown on the seed crystal, when a silicon carbide single crystal machined by ELID grinding is used as the seed crystal, is based on the lower surface roughness and the reduced level of machining damage. This relationship between ELID grinding and the number of defects in the silicon carbide single crystal grown on a seed crystal, i.e. the effect of the present invention, was completely unknown in the

### prior art.

The machining conditions for the ELID grinding may be optimized by appropriate selection of the machining method, the type and size of the abrasive, the pressing conditions, the electric field voltage and the electrolyte solution, but it is generally preferred to employ a metal bonded grinding wheel or metal resin bonded grinding wheel using abrasive (of diamond or the like) with a size in the range of approximately #300-#3,000,000 and more preferably in the range of #800-#300,000. A smaller size of an abrasive is usually preferred, but if the size is too small the polishing speed is reduced to an impractical level. It is particularly preferred to repeat the polishing while gradually lowering the abrasive grit size and/or reducing the grinding wheel hardness from a metal bond to a metal resin bond.

After machining by ELID grinding with a grinding wheel of about #8000-60,000, the surface may be finished by polishing with a slurry containing diamond abrasive grits having a mean size of no greater than 1 µm.

The following is an explanation of a concrete example of ELID grinding that may be used for production of a silicon carbide single crystal based on the present invention.

The seed crystal used for growth of the silicon carbide single crystal is a single crystal obtained by the Acheson process, and it is first cut on one side by ELID grinding. A single crystal obtained by the Lely process may also be used. The cutting is accomplished using a cast iron metal bonded cutting blade including #325 diamond abrasive. Throughout the present specification, the sizes mentioned for the diamond abrasive will be based on the JIS R6001 standard. The cutting surface is the back side of the crystal growth, and it is the side that adheres to the top of the graphite crucible used for growth. The opposite side is the crystal growth side, and it is polished by ELID grinding using an apparatus such as shown in Fig. 1. In the case of an Acheson crystal, impurities such as metals present in the starting material sometimes adhere to the Acheson crystal surface, depending on the production conditions, and in some cases follicular impurity aggregates form on the surface. In the case of such crystal growth, polishing is carried out for the purpose of removing these undesired portions.

The polishing is accomplished to approximately 100 µm rough polishing using a cast iron metal bonded disk containing #1200 diamond abrasive. Next, finish polishing is carried out with a metal resin bonded disk having a metal:resin ratio of 7:3 and containing #20,000 diamond abrasive, to remove the surface damage to the seed crystal. A metal resin bonded disk has higher elasticity than a metal bonded disk, and the finished surface roughness of the polished surface is lower than that achieved by metal bonded tools. However, for ELID grinding, electrolysis of the grinding wheel section is necessary, so that a metal content of at least 50% is necessary. The flatness of the finished seed crystal is Ra = 2 nm, Rmax = 10 nm, as measured by a surface roughness meter using the contact needle method.

The seed crystal may be used as is with its polished surface, but it may also be repolished with free abrasive. When a free abrasive is used, the polishing is preferably carried out with a slurry containing a diamond abrasive of no greater than 1 µm, in order to bring out the advantages of the ELID grinding. This is because of possible damage to the seed crystal when the abrasive has a large size. Before using it for silicon carbide single crystal growth, the completely machined seed crystal is washed with hydrofluoric acid to dissolve the metal impurities, and then thoroughly washed with purified water.

The method explained below is for growth of a silicon carbide single crystal using a seed crystal prepared by machining by ELID grinding in this manner.

Sublimation is a widely used method for growing silicon carbide single crystals, but silicon gas/carbon reaction is also effective as an alternative to sublimation.

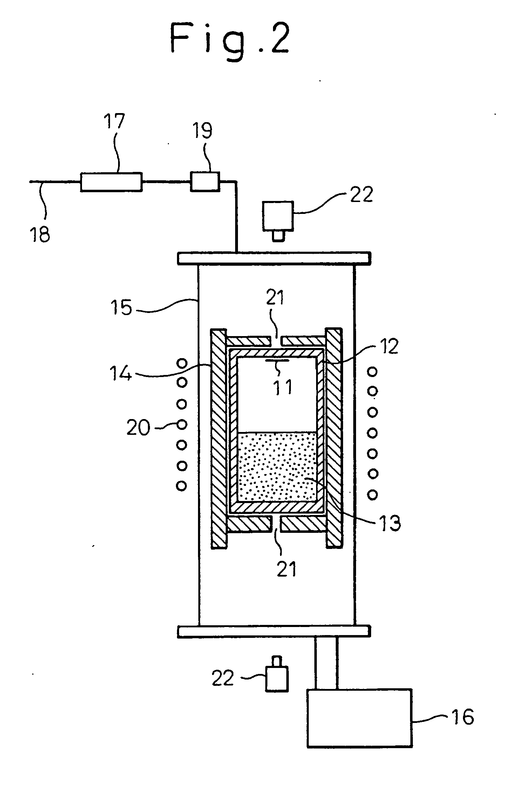

Fig. 2 shows an example of a single crystal silicon carbide growth apparatus used according to the invention. The apparatus corresponds to a publicly known improved Lely process, and it has a construction wherein a seed crystal is used for growth of a silicon carbide single crystal by sublimation. The apparatus will now be explained in a simplified overview.

A silicon carbide seed crystal 11 prepared by the present process is fixed on a graphite lid at the upper portion of a graphite crucible 12, and silicon carbide grains 13 as the starting material for silicon carbide growth are placed in the graphite crucible. The graphite crucible 12 is set inside a carbon fiber insulating material 14, and situated inside a double quartz glass reactor 15. The reactor is capable of evacuation to under 10⁻⁵ Torr by a vacuum exhaust system 16 and, during sublimation of the silicon carbide, Ar gas exchange is accomplished by an Ar gas supply line 18 with an Ar gas purifier 17. The pressure in the reactor during the sublimation is controlled by the vacuum exhaust system evacuation rate and the Ar supply rate according to a mass flow controller 19, and it may be controlled to between 0.1 and 760 Torr. The temperature control is accomplished by induction heating of the graphite crucible, by application of high frequency to a high frequency induction coil 20 outside the reactor. The high frequency induction coil can be moved up and down to control the temperature distribution of the crucible. The temperature of the graphite crucible is measured by opening holes 21 in the insulating material above and below the crucible and directly measuring the temperature of the crucible with a radiation thermometer 22.

The seed crystal used preferably has the same crystal structure as the crystal to be grown. The crystal growth face may be of any orientation. For example, the C axis perpendicular plane ({0001} plane), C axis parallel plane ({1100} plane) or an off-angle introduction plane may be used. The dimensions of the seed crystal are not particularly restricted.

The temperature of the seed crystal 11 is usually in the range of 1500-2500°C and preferably in the range of 1700-2300°C and, if the sublimation of the silicon carbide grains 13 is carried out with the region of the silicon carbide grains at a temperature of 5-400°C higher and preferably a temperature of 10-200°C higher than the region of the seed crystal 11, the gas produced by sublimation from the silicon carbide grains (Si₂C, SiC₂, Si, C, etc.) falls below the saturation vapor pressure at the surface of the seed crystal 11 which is at a lower temperature, and thus precipitates. Upon precipitation of the silicon carbide, the gas concentration falls creating a gas concentration difference in the crucible and this concentration difference drives the movement of gas.

A silicon gas/carbon reaction process will now be explained.

In the silicon gas/carbon reaction process, the seed crystal is preferably prevented from contacting the carbon starting material, and is preferably positioned as close as possible to the carbon starting material from the standpoint of movement of the reaction gas and maintaining cleanness of the crystal growth surface. In the silicon gas/carbon reaction process, the silicon starting material used is preferably of high purity to minimize crystal defects and facilitate control of the valence electrons. The silicon starting material is heated to a temperature above its melting point to generate silicon vapor. The silicon starting material is housed in a graphite crucible and the graphite crucible is heated with a high frequency heating apparatus.

The heating temperature of the silicon starting material may generally be in the range of 1450-2200°C, and preferably in the range of 1500-2000°C.

The generated silicon vapor is contacted with the heated carbon material. The carbon material used may be of any type from amorphous carbon to graphite, but for growth of high quality silicon carbide, it is preferred to use a high purity material. The high purification of the carbon material can be achieved by removing the impurities, through high temperature firing or reaction with a halogen gas. The carbon material used may have any structure so long as it allows passage of gas, in order to efficiently accomplish contact reaction of the silicon vapor. For example, it may have a porous structure or it may be constructed of layers filled with carbon powder. Porous carbon may be a carbon plate with a particularly high void volume, or a common carbon plate provided with throughholes.

The temperature of the carbon material will usually be 1600°C or above, and be a temperature higher than the seed crystal temperature, but it is preferably selected in the range of 1700-2800°C. The temperature of the seed crystal may be the same as for sublimation.

The carbon material is usually positioned above the silicon starting material in the crucible. The carbon material may even be arranged in layers, in which case for a common carbon wafer with throughholes or a porous carbon plate, they are preferably positioned so that the throughholes of each of the carbon wafers have their centers shifted, so that the gas flow does not pass directly through in a linear fashion but impacts and contacts with the carbon material. In the case of carbon powder, a plurality of layers of filled perforated disks are preferably situated in order to increase the impacting contact area between the silicon gas phase molecules and the carbon.

The carbon starting material may also be added continuously or intermittently in the amount to be consumed, similar to the silicon material. In order to maintain the atmospheric purity in the crucible, the powder may be first transported to a preparatory chamber and then the preparatory chamber is evacuated and exchanged with a growth atmosphere gas (such as argon gas), and the carbon powder is then supplied from the preparatory chamber to the crucible.

The continuous or intermittent supplying of the starting material may be with both carbon and silicon or with silicon or carbon. A system in which both carbon and silicon are not supplied, i.e. a batch system, may also be used.

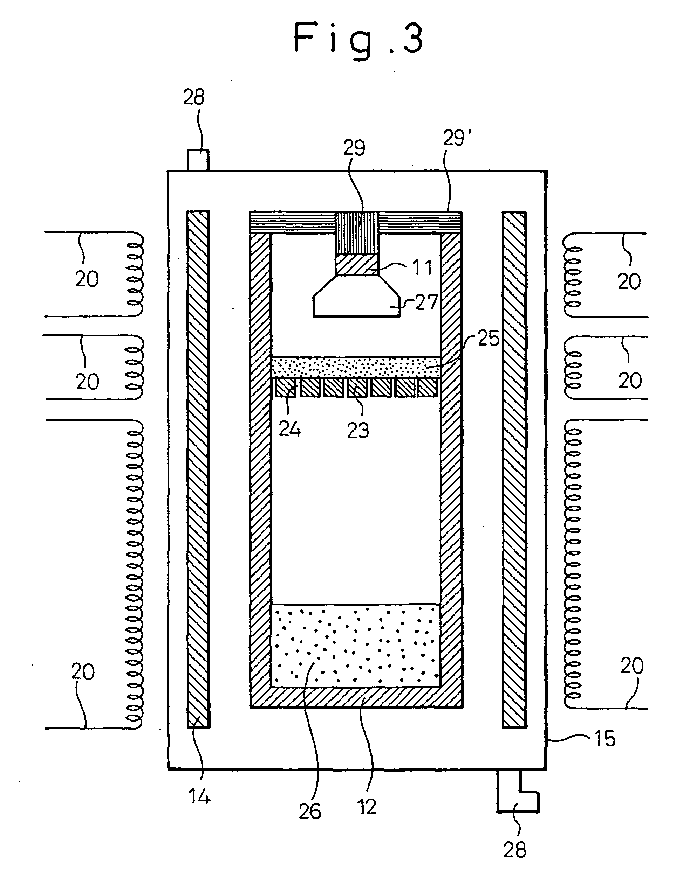

Fig. 3 shows an example of a single crystal growth apparatus based on a silicon gas/carbon reaction. A silicon starting material 26 is heated with a high frequency induction coil 20 to silicon vapor, and then contacted with a heated carbon material. The carbon material is a highly porous carbon wafer 25 in which carbon grains are filled in a disk shape 23, and after forming throughholes 24, it is placed over the silicon starting material 26 in the crucible. This allows the gas flow to impact and contact the carbon material without passing directly through. The silicon vapor that has undergone contact reaction with the carbon material is deposited as a silicon carbide single crystal 27 on the seed crystal 11. In Fig. 3, 28 is a gas inlet and outlet for control of the furnace atmosphere, and 29 is a seed crystal holding member used to increase heat release from the seed crystal.

WO99/JP14405 describes crystal growth by a silicon gas/carbon reaction, and the disclosed content of this publication is incorporated herein by reference.

Concrete examples of the present invention will now be provided.

### Examples

### (Example 1)

Using the sublimation single crystal silicon carbide growth apparatus shown in Fig. 2, a single crystal obtained by the Acheson process and modified by ELID grinding, as described above, was mounted on a graphite crucible as a seed crystal for a first crystal growth, and the crucible was filled with silicon carbide grains as the starting material. The silicon carbide grains used were of a commercially available #100 polishing material. To increase the purity of the silicon carbide starting material, it was prewashed with a mixed acid comprising hydrofluoric acid and nitric acid, and then the acid was thoroughly removed with purified water and the material was dried. The crucible was then set in a reactor and, after evacuating the system to below 10⁻⁶ Torr, Ar gas was introduced while adjusting the system to 200 Torr, and the graphite crucible was held at 1500°C for 30 minutes to remove the adsorbed gas, etc. of the starting material. Next, heating was performed to adjust the temperature of the starting material to 2300°C and the temperature of the seed crystal to 2100°C, to grow a silicon carbide single crystal.

The silicon carbide single crystal obtained by this process were confirmed to be a hexagonal silicon carbide single crystal based on the peak positions by Raman spectroscopy and the X-ray diffraction peak pattern. This silicon carbide single crystal was cut to approximately 1 mm, and upon alkali melt etching with KOH for 10 minutes at 530°C and examination of the micropipes, the number of micropipes was approximately 60 per cm².

Next, the silicon carbide single crystal ingot obtained by this process was cut by ELID grinding. The cutting was carried out to approximately 1 mm using a metal bonded cutting blade comprising #325 diamond abrasive grits. This was followed by crude polishing with a cast iron metal bonded disk comprising #1200 diamond abrasive grits, and then by semi-finish polishing with a #4000 metal resin bonded disk and finish polishing with a #20,000 metal resin bonded disk, to remove the damage from the surface, and this was then used as a seed crystal for a second crystal growth. The contact needle surface roughness of the seed crystal was measured and found to be Ra = 1.8 nm, Rmax = 9 nm, for a damage-free mirror-finished surface.

Next, using a silicon carbide single crystal growth apparatus such as shown in Fig. 2, the second growth seed crystal modified by ELID grinding was washed with hydrofluoric acid and purified water and then mounted on a graphite crucible, and the same type of silicon carbide grains as mentioned above were filled into the crucible as the starting material. The crucible was then set in a reactor, and after evacuating the system to below 10⁻⁶ Torr, Ar gas was introduced while adjusting the system to 200 Torr, and the graphite crucible was held at 1500°C for 30 minutes to remove the adsorbed gas, etc. of the starting material. Next, heating was performed to adjust the temperature of the starting material to 2300°C and the temperature of the seed crystal to 2100°C, and the silicon carbide single crystal was allowed to grow for 3 hours.

The silicon carbide single crystal obtained by this process was confirmed to be a silicon carbide single crystal with the same hexagonal system as the seed crystal, based on the peak positions by Raman spectroscopy and the X-ray diffraction peak pattern. This silicon carbide single crystal was cut to approximately 1 mm, and upon alkali melt etching with KOH for 10 minutes at 530°C and examination of the micropipes, the number of micropipes was approximately 7 per cm².

### (Example 2)

Crystal growth was carried out using a silicon gas/carbon reaction-based single crystal silicon carbide reactor such as shown in Fig. 3. The seed crystal used was the same as the second growth seed crystal machined by ELID grinding under the same conditions as in Example 1. The seed crystal was stretched over a pyrographite carbon cover, and then 23 g of semiconductor grade Si grains were loaded into the graphite crucible. The graphite crucible had an outer diameter of 32 mm, a height of 121 mm and a thickness of 4 mm. At about 20 mm from the cover, an approximately 2 mm-thick carbon wafer (3 mmφ x 21 holes) was set therein as a carbon powder support, and 2.4 g of carbon powder (Shocaraiser L, Showa Denko) was filled in thereover. The graphite crucible was set in the quartz tube of a high frequency furnace. First, the inside pressure of the reactor was reduced to 1 x 10⁻² Torr, and after filling with argon to ordinary pressure, the pressure was again reduced to 5 x 10⁻⁴ Torr to draw out the air in the reaction system. Argon was again introduced to ordinary pressure, the graphite crucible was heated and the pressure reduced to 10 Torr, and the silicon starting material temperature was kept at 1800°C, the carbon powder temperature at 2500°C and the seed crystal temperature at 2000°C, for 3 hours of crystal growth. The temperature was controlled by a sensor, such as a radiation thermometer, mounted on the outer wall of the crucible.

The silicon carbide single crystal obtained by this process was confirmed to be a hexagonal silicon carbide single crystal, based on the peak positions by Raman spectroscopy and X-ray diffraction. This crystal was examined for micropipes in the same manner as Example 1, and the number of micropipes was approximately 50 per cm².

Next, the silicon carbide single crystal ingot obtained by this process was again cut and polished using ELID grinding, and the silicon carbide single crystal growth was carried out with this as the seed crystal. When the grown crystal was examined for micropipes, the number of micropipes had been reduced to 5 per cm².

### (Comparative Example)

A single crystal obtained by the same Acheson process as the examples was cut without using ELID grinding to obtain a first growth seed crystal. The cutting was carried out in the same manner as the examples, using the metal bonded cutting blade used for the ELID grinding, but without electrolyte dressing. The polishing after cutting was also carried out using the same type of disk as the examples under the same conditions, but without electrolyte dressing. The flatness of the finished seed crystal was Ra = 12 nm, Rmax = 34 nm. After treatment of the surface under the same conditions as the examples, crystal growth was conducted under the same conditions as the examples.

The silicon carbide single crystal obtained by this process was confirmed to be a hexagonal silicon carbide single crystal, based on Raman spectroscopy and X-ray diffraction. This crystal was examined for micropipes in the same manner as the examples, and the number of micropipes was approximately 6 x 10² per cm².

Next, the silicon carbide single crystal ingot obtained by this process was again cut and polished under the same conditions but without ELID grinding, and silicon carbide single crystal growth was conducted with this as the second growth seed crystal. Upon examination for micropipes, the number of micropipes was 5 x 10² per cm², which was virtually unchanged from the seed crystal.

### Industrial Applicability

The process for producing single crystals according to the present invention can reduce defects due to seed crystals for silicon carbide single crystal growth, thereby lowering manufacturing costs by improving yields for semiconductor devices.

## Claims

1. A process for producing a silicon carbide single crystal whereby a silicon carbide single crystal is grown on a seed crystal substrate, **characterized in that** the process for producing the silicon carbide single crystal comprises
setting, as a seed crystal in a crystal growth vessel, a silicon carbide crystal which has been machined by electrolytic in-process dressing grinding and which has been treated with hydrofluoric acid, and
growing the silicon carbide single crystal on said seed crystal.

2. A process for producing a silicon carbide single crystal according to claim 1, wherein said seed crystal is a silicon carbide single crystal obtained by the Acheson or Lely process and is machined by electrolytic in-process dressing grinding.

3. A process for producing a silicon carbide single crystal according to claim 1, wherein said seed crystal is a silicon carbide single crystal grown by sublimation or silicon gas/carbon reaction and is machined by electrolytic in-process dressing grinding.

4. A process for producing a silicon carbide single crystal according to claim 1, wherein said electrolytic in-process dressing grinding includes electrolytic in-process dressing lapping.

5. A process for producing a silicon carbide single crystal according to claim 4, wherein said electrolytic in-process dressing grinding includes repeated lap grinding with a metal bonded or metal resin bonded grinding wheel employing abrasive particles in the range of #300-#3,000,000,000 based on the JIS R6001 standard.

6. A process for producing a silicon carbide single crystal according to claim 1, wherein the crystal growth surface of the seed crystal for the silicon carbide crystal machined by electrolytic in-process dressing grinding has an average surface roughness of no greater than 20 nm.

7. A process for producing a silicon carbide single crystal whereby a silicon carbide single crystal is grown on a seed crystal substrate, **characterized in that** the process for producing the silicon carbide single crystal comprises
setting, as a seed crystal in a crystal growth vessel, a silicon carbide crystal which has been machined by electrolytic in-process dressing grinding, and which has been treated with hydrofluoric acid
heating a silicon carbide starting material placed in said crystal growth vessel and sublimating the silicon carbide to form a sublimated gas, and
transporting said sublimated gas over said seed crystal to cause growth of a silicon carbide single crystal on said seed crystal.

8. A process for producing a silicon carbide single crystal whereby a silicon carbide single crystal is grown on a seed crystal substrate, **characterized in that** the process for producing the silicon carbide single crystal comprises which has been
setting, as a seed crystal in a crystal growth vessel, a silicon carbide crystal machined by electrolytic in-process dressing grinding and which has been treated with hydrofluoric acid,
heating to melt the silicon material set in said crystal growth vessel to form silicon vapor,
contacting said silicon vapor with a heated carbon material set between said silicon material and said seed crystal to form a silicon carbide-forming gas, and
transporting said silicon carbide-forming gas over said seed crystal to cause growth of a silicon carbide single crystal on said seed crystal.

9. A silicon carbide single crystal obtainable by the production process of claim 1.

10. (added) A process for producing a silicon carbide single crystal whereby a silicon carbide single crystal is grown on a seed crystal substrate, **characterized in that** the process for producing the silicon carbide single crystal comprises
setting, a seed crystal in a crystal growth vessel, a silicon carbide crystal which has been machined by electrolytic in-process dressing grinding and which has been treated with hydrofluoric acid,
growing the silicon carbide single crystal on said seed crystal,
machining the silicon carbide single crystal grown in the previous step by electrolytic in-process dressing grinding and again setting it in a crystal growth vessel as a seed crystal, and
again growing a silicon carbide single crystal on said seed crystal set in said previous step.

11. (added) A process for producing a silicon carbide single crystal according to claim 10, wherein said seed crystal is a carbon silicon single crystal obtained by the Acheson or Lely process and is machined by electrolytic in-process dressing grinding.

12. (added) A process for producing a silicon carbide single crystal according to claim 10, wherein said seed crystal is a carbon silicon single crystal grown by sublimation or silicon gas/carbon reaction and is machined by electrolytic in-process dressing grinding.

13. (added) A process for producing a silicon carbide single crystal according to claim 10, wherein said electrolytic in-process dressing grinding includes electrolytic in-process dressing lapping.

14. (added) A process for producing a silicon carbide single crystal according to claim 13, wherein said electrolytic in-process dressing grinding includes repeated lap grinding with a metal bonded or metal resin bonded grinding Wheel employing abrasive particles in the range of #300-#3,000,000 based as the JIS R6001 standard.

15. (added) A process for producing a silicon carbide single crystal according to claim 10, wherein the crystal growth surface of the seed crystal for the silicon carbide crystal machined by electrolytic in-process dressing grinding has an average surface roughness of no greater than 20 nm.

16. (added) A silicon carbide single crystal obtainable by the production process of claim 10.

## Patentansprüche

1. Verfahren zur Herstellung eines Siliciumcarbid-Einkristalls, wobei ein Siliciumcarbid-Einkristall auf einem Impfkristallsubstrat gezüchtet wird, **dadurch gekennzeichnet, dass** das Verfahren zur Herstellung des Siliciumcarbid-Einkristalls umfasst:
Setzen eines Siliciumcarbidkristalls, welcher mittels elektrolytischem In-Prozess Abrichtschleifen bearbeitet worden war und der mit Fluorwasserstoffsäure behandelt worden war, als ein Impfkristall in ein Kristallzüchtungsgefäß, und
Züchten des Siliciumcarbid-Einkristalls auf dem Impfkristall.

2. Verfahren zur Herstellung eines Siliciumcarbid-Einkristalls nach Anspruch 1, worin der Impfkristall ein Siliciumcarbid-Einkristall ist, welcher durch das Acheson- oder Lely-Verfahren erhalten wurde und durch elektrolytisches In-Prozess Abrichtschleifen behandelt wurde.

3. Verfahren zur Herstellung eines Siliciumcarbid-Einkristalls nach Anspruch 1, worin der Impfkristall ein Siliciumcarbid-Einkristall ist, welcher durch Sublimation oder Siliciumgas/Kohlenstoff-Reaktion gezüchtet wird und durch elektrolytisches In-Prozess Abrichtschleifen bearbeitet wird.

4. Verfahren zur Herstellung eines Siliciumcarbid-Einkristalls nach Anspruch 1, worin das elektrolytische in-Prozess Abrichtschleifen ein elektrolytisches In-Prozess Abrichtfeinschleifen bzw. -polieren beinhaltet.

5. Verfahren zur Herstellung eines Siliciumcarbid-Einkristalls nach Anspruch 4, worin das elektrolytische In-Prozess Abrichtschleifen ein wiederholtes Feinschleifen mit einer metallgebundenen oder metallharzgebundenen Schleifscheibe beinhaltet, bei welcher Schleifpartikel im Bereich von #300-#3.000.000, basierend auf dem JIS R6001-Standard, verwendet werden.

6. Verfahren zur Herstellung eines Siliciumcarbid-Einkristalls nach Anspruch 1, worin die Kristallwachstumsoberfläche des Impfkristalls für den Siliciumcarbidkristall, welcher mittels elektrolytischem In-Prozess Abrichtschleifen behandelt worden war, eine durchschnittliche Oberflächenrauheit von nicht größer als 20 nm aufweist.

7. Verfahren zur Herstellung eines Siliciumcarbid-Einkristalls, wobei ein Siliciumcarbid-Einkristall auf einem Impfkristallsubstrat gezüchtet wird, **dadurch gekennzeichnet, dass** das Verfahren zur Herstellung des Siliciumcarbid-Einkristalls umfasst:
Setzen eines Siliciumcarbidkristalls, welcher mittels elektrolytischem In-Prozess Abrichtschleifen bearbeitet worden war und der mit Fluorwasserstoffsäure behandelt worden war, als ein Impfkristall in ein Kristallzüchtungsgefäß,
Erhitzen eines Siliciumcarbid-Ausgangsmaterials, welches in dem Kristallzüchtungsgefäß angeordnet war, und Sublimieren des Siliciumcarbids zur Bildung eines sublimierten Gases, und
Transportieren des sublimierten Gases über den Impfkristall, um ein Wachstum eines Siliciumcarbid-Einkristalls auf dem Impfkristall zu bewirken.

8. Verfahren zur Herstellung eines Siliciumcarbid-Einkristalls, wobei ein Siliciumcarbid-Einkristall auf einem Impfkristallsubstrat gezüchtet wird, **dadurch gekennzeichnet, dass** das Verfahren zur Herstellung des Siliciumcarbid-Einkristalls umfasst:
Setzen eines Siliciumcarbidkristalls, welcher mittels elektrolytischem In-Prozess Abrichtschleifen bearbeitet worden war und der mit Fluorwasserstoffsäure behandelt worden war, als ein Impfkristall in ein Kristallzüchtungsgefäß, und
Erhitzen, um das in das Kristallzüchtungsgefäß gesetzte Siliciummaterial zu schmelzen, um Siliciumdampf zu bilden,
Kontaktieren des Siliciumdampfes mit einem erhitzten Kohlenstoffmaterial, das zwischen das Siliciummaterial und den Impfkristall gebracht worden war, um ein Siliciumcarbidbildendes Gas zu bilden, und
Transportieren des Siliciumcarbid-bildenden Gases über den Impfkristall, um ein Wachstum eines Siliciumcarbid-Einkristalls auf dem Impfkristall zu bewirken.

9. Siliciumcarbid-Einkristall, erhältlich durch das Herstellungsverfahren von Anspruch 1.

10. Verfahren zur Herstellung eines Siliciumcarbid-Einkristalls, wobei ein Siliciumcarbid ein Kristall auf einem Impfkristallsubstrat gezüchtet wird, **dadurch gekennzeichnet, dass** das Verfahren zur Herstellung des Siliciumcarbid-Einkristalls umfasst:
Setzen eines Siliciumcarbidkristalls, welcher mittels elektrolytischem In-Prozess Abrichtschleifen bearbeitet worden war und der mit Fluorwasserstoffsäure behandelt worden war, als ein Impfkristall in ein Kristallzüchtungsgefäß, und
Züchten des Siliciumcarbid-Einkristalls auf dem Impfkristall,
Bearbeiten des Siliciumcarbid-Einkristalls, welcher in dem vorangehenden Schritt gezüchtet wurde, durch elektrolytisches In-Prozess Abrichtschleifen und Wiedereinsetzen dieses in ein Kristallzüchtungsgefäß als Impfkristall, und
wieder Züchten eines Siliciumcarbid-Einkristalls auf dem Impfkristall, der in dem vorangehenden Schritt eingesetzt wurde.

11. Verfahren zur Herstellung eines Silciumcarbid-Einkristalls nach Anspruch 10, wobei der Impfkristall ein Kohlenstoff-Silicium-Einkristall ist, der durch das Acheson- oder Lely-Verfahren erhalten wurde und mittels elektrolytischem In-Prozess Abrichtschleifen behandelt wurde.

12. Verfahren zur Herstellung eines Siliciumcarbid-Einkristalls nach Anspruch 10, worin der Impfkristall ein Kohlenstoff-Silicium-Einkristall ist, der durch Sublimation oder Siliciumgas/Kohlenstoff-Reaktion wird und durch elektrolytisches In-Prozess Abrichtschleifen bearbeitet wird.

13. Verfahren zur Herstellung eines Siliciumcarbid-Einkristalls nach Anspruch 10, worin das elektrolytische In-Prozess Abrichtschleifen ein elektrolytisches In-Prozess Abrichtfeinschleifen bzw. -polieren beinhaltet.

14. Verfahren zur Herstellung eines Siliciumcarbid-Einkristalls nach Anspruch 13, worin das elektrolytische In-Prozess Abrichtschleifen ein wiederholtes Feinschleifen mit einer metallgebundenen oder metallharzgebundenen Schleifscheibe beinhaltet, bei welcher Schleifpartikel im Bereich von #300-#3.000.000, basierend auf dem JIS R6001-Standard, verwendet werden.

15. Verfahren zur Herstellung eines Siliciumcarbid-Einkristalls nach Anspruch 10, worin die Kristallwachstumsoberfläche des Impfkristalls für den mittels elektrolytischem In-Prozess Abrichtschleifen bearbeiteten SiliciumcarbidKristall eine durchschnittliche Oberflächenrauheit von nicht größer als 20 nm aufweist.

16. Siliciumcarbid-Einkristall, erhältlich durch das Herstellungsverfahren nach Anspruch 10.

## Revendications

1. Procédé de production d'un monocristal de carbure de silicium moyennant quoi un monocristal de carbure de silicium se développe sur un substrat de germes cristallins, **caractérisé en ce que** le procédé de production du monocristal de carbure de silicium comprend les étapes consistant à :
déposer, en guise de germe cristallin dans une cuve à croissance de cristaux, un cristal de carbure de silicium qui a été usiné par un broyage dressage en cours électrolytique, et qui a été traité avec de l'acide fluorhydrique, et à
faire croître le monocristal de carbure de silicium sur ledit germe cristallin.

2. Procédé de production d'un monocristal de carbure de silicium selon la revendication 1, dans lequel ledit germe cristallin est un monocristal de carbure de silicium obtenu par la méthode d'Acheson ou de Lely et qui est usiné par un broyage dressage en cours électrolytique.

3. Procédé de production d'un monocristal de carbure de silicium selon la revendication 1, dans lequel ledit germe cristallin est un monocristal de carbure de silicium développé par sublimation ou par une réaction silicium/carbone et qui est usiné par broyage dressage en cours électrolytique.

4. Procédé de production d'un monocristal de carbure de silicium selon la revendication 1, dans lequel ledit broyage dressage en cours électrolytique comprend le rodage dressage en cours électrolytique.

5. Procédé de production d'un monocristal de carbure de silicium selon la revendication 4, dans lequel ledit broyage dressage en cours électrolytique comprend le broyage par recouvrement répété avec une meule liée par le métal ou liée par la résine utilisant des particules abrasives dans la gamme de 300 à 3 000 000 par rapport à la norme JIS R6001.

6. Procédé de production d'un monocristal de carbure de silicium selon la revendication 1, dans lequel la surface de croissance des cristaux du germe cristallin pour le cristal de carbure de silicium usiné par broyage dressage en cours électrolytique a une rugosité de surface moyenne ne dépassant pas 20 nm.

7. Procédé de production d'un monocristal de carbure de silicium moyennant quoi un monocristal de carbure de silicium se développe sur un substrat de germe cristallin, **caractérisé en ce que** le procédé de production du monocristal de carbure de silicium comprend les étapes consistant à :
déposer, en guise de germe cristallin dans une cuve à croissance de cristaux, un cristal de carbure de silicium qui a été usiné par un broyage dressage en cours électrolytique, et qui a été traité avec de l'acide fluorhydrique,
chauffer une matière première de carbure de silicium placée dans ladite cuve à croissance de cristaux et à sublimer le carbure de silicium pour former un gaz sublimé, et
transporter ledit gaz sublimé au-dessus dudit germe cristallin pour entraîner le développement d'un monocristal de carbure de silicium sur ledit germe cristallin.

8. Procédé de production d'un monocristal de carbure de silicium moyennant quoi un monocristal de carbure de silicium se développe sur un substrat de germe cristallin, **caractérisé en ce que** le procédé de production du monocristal de carbure de silicium comprend les étapes consistant à :
déposer, en guise de germe cristallin dans une cuve à croissance de cristaux, un cristal de carbure de silicium qui a été usiné par un broyage dressage en cours électrolytique, et qui a été traité avec de l'acide fluorhydrique,
chauffer pour faire fondre le matériau de silicium déposé dans ladite cuve à croissance de cristaux pour former de la vapeur de silicium,
mettre en contact ladite vapeur de silicium avec un matériau de carbone chauffé déposé entre ledit matériau de silicium et ledit germe cristallin pour former un gaz formant du carbure de silicium, et
transporter ledit gaz formant du carbure de silicium au-dessus dudit germe cristallin pour entraîner le développement d'un monocristal de carbure de silicium sur ledit germe cristallin.

9. Monocristal de carbure de silicium pouvant être obtenu par le procédé de production selon la revendication 1.

10. Procédé de production d'un monocristal de carbure de silicium moyennant quoi un monocristal de carbure de silicium se développe sur un substrat de germe cristallin, **caractérisé en ce que** le procédé de production du monocristal de carbure de silicium comprend les étapes consistant à :
déposer, en guise de germe cristallin dans une cuve à croissance de cristaux, un cristal de carbure de silicium qui a été usiné par un broyage dressage en cours électrolytique, et qui a été traité avec de l'acide fluorhydrique,
faire croître le monocristal de carbure de silicium sur ledit germe cristallin,
usiner le monocristal de carbure de silicium de l'étape précédente par un broyage dressage en cours électrolytique et le déposer de nouveau dans une cuve à croissance de cristaux en guise de germe cristallin, et
faire croître de nouveau un monocristal de carbure de silicium sur ledit germe cristallin déposé dans ladite étape précédente.

11. Procédé de production d'un monocristal de carbure de silicium selon la revendication 10, dans lequel ledit germe cristallin est un monocristal de carbure de silicium obtenu par la méthode d'Acheson ou de Lely et qui est usiné par un broyage dressage en cours électrolytique.

12. Procédé de production d'un monocristal de carbure de silicium selon la revendication 10, dans lequel ledit germe cristallin est un monocristal de carbure de silicium développé par sublimation ou par une réaction silicium/carbone et qui est usiné par un broyage dressage en cours électrolytique.

13. Procédé de production d'un monocristal de carbure de silicium selon la revendication 10, dans lequel ledit broyage dressage en cours électrolytique comprend le rodage dressage en cours électrolytique.

14. Procédé de production d'un monocristal de carbure de silicium selon la revendication 13, dans lequel ledit broyage dressage en cours électrolytique comprend le broyage par recouvrement répété avec une meule liée par le métal ou liée par la résine utilisant des particules abrasives dans la gamme de 300 à 3 000 000 par rapport à la norme JIS R6001.

15. Procédé de production d'un monocristal de carbure de silicium selon la revendication 10, dans lequel la surface de croissance des cristaux du germe cristallin pour le cristal de carbure de silicium usiné par un broyage dressage en cours électrolytique a une rugosité de surface moyenne ne dépassant pas 20 nm.

16. Monocristal de carbure de silicium pouvant être obtenu par le procédé de production selon la revendication 10.
